# EUROPEAN PATENT SPECIFICATION

(11) **EP 3 252 015 B1**
(45) Date of publication and mention of the grant of the patent: **12.08.2020**
(21) Application number: 16743223.6
(22) Date of filing: 21.01.2016
(51) Int. Cl.: C01G 49/00, C01G 53/00, C09C 1/24, H01F 1/36, H05K 9/00, C09D 5/36, C09D 7/40, C01G 49/06

(54) **PLATE-SHAPED FERRITE PARTICLES FOR PIGMENT WHICH EXHIBIT METALLIC LUSTRE**
PLATTENFÖRMIGE FERRITTEILCHEN FÜR PIGMENT MIT METALLISCHEM GLANZ
PARTICULES DE FERRITE LAMELLAIRES POUR PIGMENT QUI CONFÈRENT UN LUSTRE MÉTALLIQUE

(30) Priority: 27.01.2015 JP 2015013782
(43) Date of publication of application: 06.12.2017
(73) Proprietor: Powdertech Co., Ltd., Kashiwa-shi, Chiba 277-8557 (JP)
(72) Inventor: AGA, Koji, Kashiwa-shi Chiba 277-8557 (JP); IGARASHI, Tetsuya, Kashiwa-shi Chiba 277-8557 (JP)
(74) Representative: Vossius & Partner Patentanwälte Rechtsanwälte mbB
(86) International application number: PCT/JP2016/051717
(87) International publication number: WO 2016/121619

(56) References cited:
- EP-A2- 0 379 805
- JP-A- S6 163 531
- JP-A- S6 163 531
- JP-A- H10 233 309
- JP-A- H10 233 309
- JP-A- S60 204 627
- JP-A- S61 295 237
- JP-A- 2000 252 113
- JP-A- 2001 015 312
- JP-A- 2001 284 118
- US-A- 4 681 367
- US-A- 4 826 537

## Description

### [Technical Field]

The present invention relates to plate shaped ferrite particles having a metallic luster for a pigment, and more particularly to plate shaped ferrite particles for a pigment having electromagnetic wave shielding ability and designability, a resin molded material containing the plate shaped ferrite particles for a pigment, and an electromagnetic wave shield housing for storing an electronic circuit manufactured by using the resin molded material.

### [Background Art]

In recent digital electronic communication equipment with high performance and miniaturization, there is a concern that electromagnetic waves generated in other equipment may cause a malfunction in the equipment as noise, or may have negative influence on human body. So, the requirement on electromagnetic wave absorbing materials or electromagnetic shielding materials which prevent leakage of electromagnetic waves from a source or block electromagnetic waves from the outside has been increased. Especially, the electromagnetic wave absorbing material or electromagnetic shielding material excellent in a high-frequency region is required because signal transfer is accelerated with higher frequencies to accelerate the data transfer speed and processing speed.

Conventionally, ferrite materials have been used as an electromagnetic wave absorbing material or electromagnetic shielding material because of a high magnetic permeability, and the electromagnetic wave absorbing property of the ferrite is that the electromagnetic wave absorbing region corresponds to the frequency region equal to or higher than the natural resonance frequency of the ferrite.

It is known that the shape of ferrite has many effects on electromagnetic wave absorbing properties, and a plate shaped or flaky shaped ferrite fills the gap between the particles by orientation and reduces the leakage of electromagnetic waves.

Various methods are proposed to manufacture such plate shaped or flaky shaped ferrite particles.

Patent Document 1 (Japanese Patent Laid-Open No. 10-233309) discloses the flaky ferrite powder having the length in the longitudinal direction of 1 to 100 µm and the aspect ratio of 5 to 100 manufactured by pulverizing the soft magnetic ferrite prepared by casting. The manufacturing method includes the melting step of melting raw materials of the soft magnetic ferrite under the specified atmosphere, the casting step of casting the molten ferrite prepared in the melting step in the casting mold preheated under the specified atmosphere and then cooling the molten ferrite under specified conditions to manufacture the ingot of the soft magnetic ferrite, and the pulverizing step of pulverizing the ingot prepared in the casting step with pulverizing means.

The flaky ferrite powder disclosed in Patent Document 1 improves the magnetic field shielding properties in a high-frequency region of 1000 MHz or more if contained in the sheet-shaped magnetic field shielding material because the ferrite powder is oriented in the direction along with the sheet surface.

In addition, the manufacturing method may simplify the manufacturing process of the ferrite powder for the magnetic field shielding material in the sheet form because the manufacturing method makes manufacturing of the flaky ferrite powder easy by only pulverizing the ingot of ferrite cast under preset conditions without difficult operations such as pulverizing of the spherical powder, and the method has the great industrial value.

Patent Document 2 (Japanese Patent Laid-Open No. 2001-284118) discloses the ferrite powder containing flaky ferrite particles, and at least a part of the flaky ferrite particles have the maximum major diameter d in the range of 1 µm or more and 100 µm or less, and the ratio (d/t) between the maximum major diameter d and the thickness t in the range is 2.5≤ (d/t). The manufacturing method including the steps of molding the sheet from a raw material of ferrite, firing the sheet to finish the ferrite, and pulverizing the sheet of the ferrite to manufacture ferrite particles containing flaky ferrite particles is described.

Patent Document 2 discloses that ferrite particles suitable for manufacturing the composite magnetic molded product that has the high magnetic permeability, is excellent in noise absorbing properties in a high-frequency band and is high in insulation reliability can be manufactured, and the manufacturing method can easily and stably manufacture the ferrite particles.

Patent Document 3 (Japanese Patent Laid-Open 2000-252113) discloses the soft magnetic ferrite particle powder having the plate shape and the composition represented by MgₐCu_{b}Zn_{c}Fe_{d}O₄ (wherein 0.3<a<0.5, 0≤b≤0.2, 0.4≤c≤0.6, and 1.8≤d≤2.2), and the soft magnetic ferrite particle composite material made therefrom. Patent Document 3 also discloses that the soft magnetic ferrite particle composite material containing the soft magnetic ferrite particle powder mixed in the matrix has the high real part of the specific magnetic permeability in the low frequency range, absorbs electromagnetic waves in the wide band in the high frequency range, and is excellent in formability and high in flexibility. The soft magnetic ferrite particle powder disclosed in Patent Document 3 can be manufactured by using plate shaped α-Fe₂O₃ as the source of Fe element and firing the raw materials of ferrite at the temperature of 1200°C or lower.

However, no plate shaped or flaky shaped ferrite powder having desired properties with stable quality is manufactured by any of the manufacturing methods disclosed in Patent Documents 1 to 3.

So, a method including the steps of coating the ferrite raw materials of various metal oxides or calcined powder on a base material with an organic solvent, followed by firing after removing the organic solvent has been proposed.

Patent Document 4 (Japanese Patent Laid-Open No. 2001-15312) discloses the manufacturing method of an electromagnetic wave absorbing magnetic paste including the steps of coating the liquid mixture of ferrite fine powder and a binder on the film to prepare the ferrite sheet, peeling the ferrite sheet from the film, pulverizing the ferrite sheet followed by firing to prepare the ferrite powder, and mixing the ferrite powder with the paste material. The manufacturing method disclosed in Patent Document 4 enables manufacturing of the electromagnetic wave absorbing magnetic paste containing ferrite particles having an aspect ratio of 10 or more, and the electromagnetic wave absorbing magnetic paste absorbs high-frequency electromagnetic waves in the wide band with the high absorptivity.

However, if just the ferrite sheet is intended to peel from the film as disclosed in Patent Document 4, the ferrite sheet is destroyed and preparation of the ferrite powder in a stable state is made difficult. Not to destroy the ferrite sheet in peeling from the film, a large amount of binder component added is required in the coating liquid mixture, and increased amount of the binder component generates voids in ferrite and hinders the grain growth in firing.

On the other hand, recent electronic equipment including cellular phones are required to have designability as well as electromagnetic wave shielding ability. The magnetic powder processed to be contained in an electromagnetic wave shielding sheet is mounted in the vicinity of an electronic circuit set inside of the housing of electronic equipment. However, as the sheet inside the housing is not shown to consumers (users), designability has not been considered. However, balancing among the design of the housing for storing an electronic circuit, various antenna shapes, and noise control generated from an electronic circuit tends to be difficult.

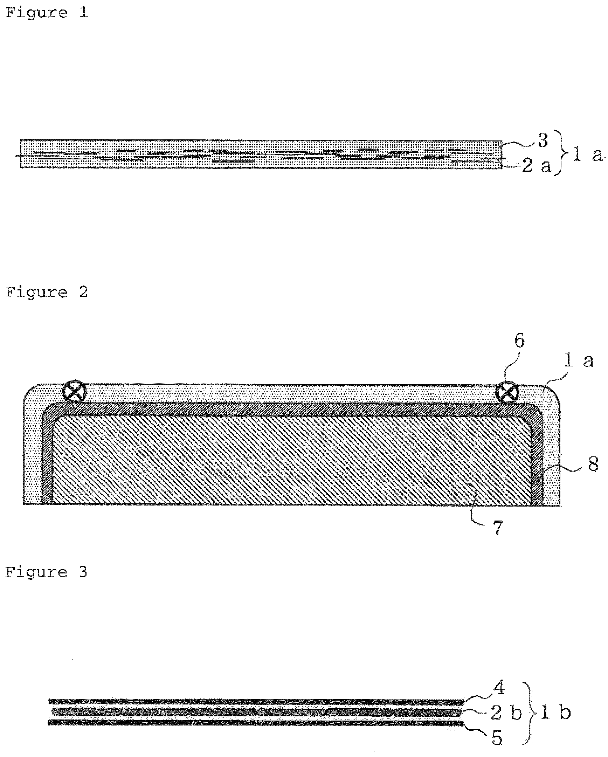

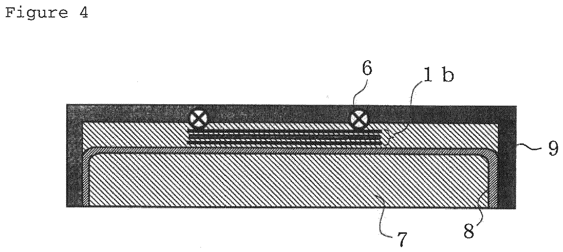

The soft magnetic ferrite particle composite material disclosed in Patent Document 3 contains gray or black ferrite particle powder in the tile form and is just attached to the electronic circuit in the case of a cellular phone. Figures 3 and 4 show cross-sectional views of the resin molded material prepared by using the plate shaped ferrite and the cross-sectional view of the electromagnetic wave shield housing part for storing the electronic circuit with use of the resin molded material. Figure 3 shows the resin molded material 1b, the ferrite particles layer 2b, the protective layer 4, and the adhesive layer 5. The resin molded material 1b is the laminate of the protective layer 4, the ferrite particles layer 2b, and the adhesive layer 5. Figure 4 shows the antenna coil 6, the electronic circuit 7, the electromagnetic wave shield 8 manufactured by using metal, and the housing (case) 9 made of resin. The resin molded material 1b in Figure 4 is adhered to the electromagnetic wave shield manufactured by using metal 8 through the adhesive layer 5, and the housing (case) 9 made of the resin does not shield radio waves.

As shown in Figures 3 and 4, the ferrite particles layer 2b constitutes the resin molded material 1b in the tile form together with the protective layer 4 and the adhesive layer 5, the resin molded material is just attached to the electronic circuit 7 in the housing (case) 9 made of resin in the cellular phone.
Patent Document 5 relates to a specific process for the production of an anisometric yellow-brown zinc ferrite pigment.
Patent Document 6 relates to a specific non-magnetic pigment comprising plate-like potassium ferrite particles.
Patent Document 7 relates to specific flaky ferrite particles.
Patent Document 8 relates to a specific lamellar pigment based on iron oxide.

### [Citation List]

### [Patent Document]

Patent Document 1: Japanese Patent Laid-Open No. 10-233309
Patent Document 2: Japanese Patent Laid-Open No. 2001-284118
Patent Documentm 3: Japanese Patent Laid-Open No. 2000-252113
Patent Document 4: Japanese Patent Laid-Open No. 2001-15312
Patent Document 5: US 4,681,637 A
Patent Document 6: EP 0 379 805 A2
Patent Document 7: JP S61 63531 A
Patent Document 8: US 4,826,537 A

As described above, no ferrite particle for a pigment, which achieves both of the electromagnetic wave shielding ability and the designability, exists yet.

### [Summary of Invention]

### [Problems to be Solved]

An object of the present invention is to provide a plate shaped ferrite particle for a pigment having both of electromagnetic wave shielding ability and designability, a resin molded material containing the plate shaped ferrite particles for a pigment, and an electromagnetic wave shield housing made of the resin molded material for storing an electronic circuit.

### [Means to Solve the Problem]

Through extensive investigation to solve the problems described above, the present inventors thought out the plate shaped ferrite particles having a metallic luster can achieve the object described above that have electromagnetic wave shielding ability and designability, and the present invention was accomplished.

The present invention provides a plate shaped ferrite particle for a pigment characterized in having a metallic luster.

The plate shaped ferrite particles for a pigment according to the present invention have a length in the minor axis direction of 3 to 100 µm, and a length in the major axis direction of 10 to 2000 µm. The surface roughness (Ra) thereof is 0.01 to 3 µm as measured with a laser microscope.

The present invention also provides a resin molded material containing the plate shaped ferrite particles for a pigment.

The present invention also provides an electromagnetic wave shield housing for storing an electronic circuit made of the resin molded material as well as the corresponding use.

### [Advantages of the Invention]

The plate shaped ferrite particles for a pigment according to the present invention have not only electromagnetic wave shielding ability but also designability because the plate shaped ferrite particles have a metallic luster. If the plate shaped ferrite particles are used for a pigment in preparation of the resin molded material, an electromagnetic wave shield housing for storing an electronic circuit can be manufactured by using the resin molded material. Since the ferrite particles are not in a tile form, the resin molded material prepared by using a resin has flexibility and the electromagnetic wave shield housing can be subjected to curving surface processing. Further, the electromagnetic wave shield housing has designability because the plate shaped ferrite particles have a metallic luster. The electromagnetic wave shield housing can be used for a long period because the ferrite as an oxide causes no surface oxidation.

### [Brief Description of Drawings]

[Figure 1] Figure 1 is a cross-sectional view of a resin molded material prepared by using the plate shaped ferrite particles according to the present invention.
[Figure 2] Figure 2 is a cross-sectional view of an electromagnetic wave shield housing for storing an electronic circuit manufactured by using the resin molded material according to the present invention.
[Figure 3] Figure 3 is a cross-sectional view of a resin molded material prepared by using a conventional plate shaped ferrite.
[Figure 4] Figure 4 is a cross-sectional view of an electromagnetic wave shield housing for storing an electronic circuit manufactured by using a conventional resin molded material.

### [Preferred Embodiments of the Invention]

The embodiments of the present invention will be described.

### <Plate shaped ferrite particles according to the present invention>

The plate shaped ferrite particles according to the present invention are used for a pigment because the plate shaped ferrite particles have a metallic luster. The term "ferrite particles" in the present invention refer to a mass of individual ferrite particles unless otherwise noted, and the simple term "particles" refer to individual ferrite particles.

The metallic luster shows only for a ferrite particle's surface having a smooth surface with light reflecting in the incident direction, the surface shines in a white color. If light does not reflect in the incident direction, a ferrite particle shows a black color inherent to the ferrite composition. The smoothness of the ferrite particle's surface will be described later.

The plate shaped ferrite particles according to the present invention have the length in the minor axis direction of 3 to 100 µm, and the length in the major axis direction of 10 to 2000 µm.

If the length in the minor axis direction is less than 3 µm, too thin ferrite particles crack due to the poor strength. If so, a sufficient metallic luster may not be achieved. If the length exceeds 100 µm, ferrite particles project from the curved surface and no resin molded material having a smooth curved surface may be achieved when a molding having a curved surface should be manufactured by using a resin composition containing ferrite particles. If the length in the major axis direction is less than 10 µm, incident light cannot be sufficiently reflected, and a metallic luster cannot be achieved. If the length exceeds 2000 µm, the particles may bond to each other by melting in final firing and the thickness in the minor axis direction tends to increase. As a result, a plate shaped particle having a desired thickness cannot be manufactured.

### <Determination of lengths in major axis direction and in minor axis direction, and aspect ratio>

The length of the major axis direction (plate diameter) is determined as follows. Images of the particles are photographed with SEM at a magnification of 35, and the image is printed out on an A4-size paper for each visual field. The horizontal Feret diameter of a particle is examined with a ruler, and the arithmetic average of 100 particles is presumed as the average length in the major axis direction (average plate diameter).

The length of the minor axis direction (thickness) is determined after preparing the specimen for examination in the following method.

9 g of the ferrite particles prepared and 1 g of powder resin are put in a 50-cc glass bottle, and are mixed with a ball mill for 30 minutes. The mixture is put in a dice with a diameter of 13 mm to pressure mold under a pressure of 30 MPa. The molded material in a vertically standing state is embedded in a resin and polished with a polishing machine to finish the specimen for examining the thickness, with the cross section of the molded material in a visible state. The specimen for examining the thickness is photographed with SEM at a magnification of 50, and the length in the minor axis direction (thickness) of the particles prepared is examined. The arithmetic average of 100 particles is presumed as the average length in the minor axis direction (average thickness).

The aspect ratio is calculated as (aspect ratio)=(average length in major direction)/(average length in minor axis direction) based on the average length in the major axis direction (average plate diameter) and the average length in the minor axis direction (average thickness) determined by the examining method described above.

The plate shaped ferrite particle according to the present invention has the surface roughness (Ra) measured with a laser microscope of 0.01 to 3 µm. If the surface roughness (Ra) is in the range, the plate shaped ferrite particle achieves the metallic luster. The surface roughness (Ra) measured with a laser microscope never be less than 0.01 µm due to the slight difference in the growth rate of grains in the final firing. If the surface roughness exceeds 3 µm, the incident light is reflected or absorbed in various directions due to the large roughness of the surface and no metallic luster is achieved.

### (Determination of the surface roughness (Ra) measured with a laser microscope)

The examination is carried out in accordance with JIS B 0601-2001.

### <Manufacturing method of the plate shaped ferrite particles according to the present invention>

The manufacturing method of the plate shaped ferrite particles according to the present invention includes preparing of a hydrophilic ink containing a filler in advance. Examples of the filler include a metal oxide, a metal carbonate, a metal hydroxide, and the mixture thereof. The raw materials of ferrite are mixed with a Henschel mixer and the like, and the mixture is then pelletized with a roller compacter. The pellets are then calcined at a firing temperature of 1000°C with a rotary kiln in the air atmosphere, for example.

The calcined material prepared is roughly pulverized and then finely pulverized. Then, water content is adjusted to finish a calcined material in a cake form. To the calcined material in the cake form is added a dispersant and dispersed with a homogenizer to prepare the hydrophilic ink. Then, a binder is added to the hydrophilic ink.

The ink finished is coated on a film with a comma coater to make the thickness of the coated ink in the specific range. After coating, and water contained is removed, and the whole including the film is immersed in a solvent such as methyl ethyl ketone to peel the ink. Then, the solvent is removed to prepare the plate shaped granulated material prepared before firing (ferrite precursor).

The plate shaped granulated material prepared before firing (ferrite precursor) is subjected to binder removing followed by final firing. The fired product is then pulverized to manufacture the plate shaped ferrite particles in the specified form.

Surface roughness of the hydrophobic base material is preferably 5 µm or less in manufacturing of the plate shaped ferrite particles to achieve a metallic luster. If the surface roughness exceeds 5 µm, the irregularities on the surface of a coated ink tend to be large, and no metallic luster is achieved. The solid content of the ink is preferably 50 to 87 wt%, more preferably 65 to 85 wt%. If the solid content is less than 50 wt%, the hydrophilic ink is repelled by the hydrophobic base material, and no ink is coated. As a result, no plate shaped granulated material is manufactured. If the solid content exceeds 87 wt%, the ink has poor spreadability because the viscosity of the ink is too high, and it may makes coating of the ink impossible. The viscosity of the ink is preferably 500 to 2500 cp. If the viscosity is less than 500 cp, the hydrophilic ink is repelled by the hydrophobic base material, and no ink is coated. As a result, no plate shaped granulated material is manufactured. If the viscosity exceeds 2500 cp, the ink has poor spreadability and it may makes coating of the ink impossible.

### <Resin molded material according to the present invention>

The resin molded material according to the present composition is manufactured by heat curing the resin composition prepared by mixing the ferrite particles described above with a resin. The resin composition contains 50 to 99.5 wt% of the plate shaped ferrite particles described above. If the content of the ferrite particles is less than 50 wt%, the properties of ferrite cannot be sufficiently achieved even if the ferrite particles are contained. If the content of the ferrite particles exceeds 99.5 wt%, molding may be impossible because almost no resin is contained.

The resin used in the resin composition preferably has flexibility. If the resin having flexibility is used, the curved surface is processed in the resin molded material. Examples of the resin include an epoxy resin, a phenol resin, a melamine resin, a urea resin and a fluorine-contained resin, and they are not specifically limited. The resin composition contains a curing agent, a curing accelerator, and various additives such as silica particles according to needs.

The cross-sectional view of the resin molded material according to the present invention is shown in Figure 1. The resin molded material 1a shown in Figure 1 includes plate shaped ferrite particles 2a and the resin 3. As described above, using of a resin having flexibility enables the curved surface processing in the resin molded material la.

### <Electromagnetic wave shield housing according to the present invention>

The cross-sectional view of an electromagnetic wave shield housing for storing an electronic circuit manufactured by using the resin molded material according to the present invention is shown in Figure 2, and the same symbols as in Figure 4 show the same. In Figure 2, the resin molded material 1a having a curved surface is disposed on the outer peripheral surface of an electromagnetic wave shield housing 8 made of metal, and the electromagnetic wave shield housing (seal) is formed.

The present invention will be more specifically described with reference to Examples as follows.

### <Example 1>

### (Preparation of the ink)

Iron oxide, nickel oxide, zinc oxide, and copper oxide were weighed to adjust composition. Fe₂O₃: 49 mol, NiO: 15 mol, ZnO: 30 mol, and CuO: 6 mol were mixed with the Henschel mixer. Then, the mixture was pelletized with the roller compacter, and then calcined in a rotary kiln at a calcining temperature of 1000°C in the air atmosphere.

The calcined material prepared was roughly pulverized with the rod mill and then finely pulverized with a wet bead mill. Then, the calcined material in the cake form was prepared by adjusting the water content in the calcined material. To the calcined material in the cake form was added the dispersant and they were dispersed with a homogenizer to prepare the hydrophilic ink. The binder (PVA) in the amount of 2 wt% relative to the water content of the hydrophilic ink was further added. Thus, a hydrophilic ink having a solid content of 80% by weight was obtained.

### (Coating and peeling from coated surface)

The hydrophilic ink prepared was coated on the commercially available PET film (thickness: 50 µm) with the comma coater to make the wet thickness 12 µm. After finishing the coating, water content was removed and the whole including the PET film was immersed in MEK to peel off the ink. The MEK was then removed to prepare the plate shaped granulated material before firing (ferrite precursor).

### (Firing)

The plate shaped granulated material before firing (ferrite precursor) prepared was subjected to binder removing in the air at 650°C. Then final firing was carried out in the air atmosphere at 1220°C for 4 hours. The fired material prepared had the plate shape. Then, the fired material was pulverized to manufacture the plate shaped ferrite particles having the length in the minor axis direction of 9 µm and the length in the major axis direction of 352 µm.

### <Example 2>

The plate shaped ferrite particles were prepared in the same manner as in Example 1, except that the solid content of the ink was 85 wt%.

### <Example 3>

The plate shaped ferrite particles were prepared in the same manner as in Example 1, except that the solid content of the ink was 70 wt%.

### <Example 4>

The plate shaped ferrite particles were prepared in the same manner as in Example 1, except that the firing temperature was 1165°C.

### <Example 5>

The plate shaped ferrite particles were prepared in the same manner as in Example 1, except that the wet thickness in the coating was 38 µm.

### <Example 6>

The plate shaped ferrite particles were prepared in the same manner as in Example 1, except that the wet thickness in the coating was 8 µm .

### <Comparative Example 1>

The plate shaped ferrite particles were prepared in the same manner as in Example 1, except that the firing temperature was 1050°C.

### <Comparative Example 2>

The plate shaped ferrite particles were prepared in the same manner as in Example 1, except that the firing temperature was 1310°C.

Table 1 shows the molar ratio of the raw materials charged, the calcination conditions (firing temperature and firing atmosphere), the fine pulverization (slurry particle diameter) and the hydrophilic ink (solid content, binder content and viscosity) in Examples 1 to 6 and Comparative Examples 1 to 2. Table 2 shows the coating conditions (coating method, film traveling speed, film surface temperature, and liquid for peeling), the binder removing conditions (treatment temperature and heating atmosphere), and the final firing conditions (firing temperature and firing atmosphere). Table 3 shows the properties of the plate shaped ferrite particle (presence/absence of metallic luster, length in major axis direction, length in minor axis direction, aspect ratio, surface roughness measured with the laser microscope, BET specific surface area, magnetic permeability, and magnetic properties).

The BET specific surface area, the magnetic permeability, and the magnetic properties in Table 3 are determined as follows. The other examination methods are as described above.

### (Determination of BET specific surface area)

The BET specific surface area was examined by the specific surface area analyzer (Macsorb HM model 1208 (manufactured by Mountech Co.)). The sample in the amount of about 5 to 7 grams was placed in the standard sample cell for the exclusive use in the specific surface area analyzer and was accurately weighed with an analytical balance, and the sample (ferrite particles) was set in an examination port to start the examination. The examination was carried out by the one-point method. After finishing the examination, BET specific surface area was automatically calculated by input of the weight of the sample. As the pre-treatment before examination, the sample in the amount of about 20 grams was separately taken onto the medicine wrapping paper and then degassed to -0.1 MPa with the vacuum dryer. After confirming that the degree of vacuum reached -0.1 MPa or less, the sample was heated at 200°C for 2 hours.

Environment: temperature; 10 to 30°C, humidity; relative humidity at 20 to 80%, without condensation.

### (Determination of the frequency properties of the complex magnetic permeability)

The frequency properties of the complex magnetic permeability were examined as follows.

The examination was carried out using the RF impedance/material analyzer E4991A manufactured by Agilent Technologies Inc., with an electrode for examining magnetic material 16454A.

The sample for examining the frequency properties of complex magnetic permeability (hereinafter simply referred to as "sample for examining complex magnetic permeability") was prepared as follows. 9 grams of plate shaped ferrite particles for suppressing noise and 1 gram of the binder resin (Kynar 301F: polyvinylidene fluoride) were weighed and placed in the 50-cc glass bottle for stirring and mixing for 30 minutes with the ball mill at 100 rpm.

After finishing stirring, about 0.6 grams of the mixture was weighed and injected into the dice with the inner diameter of 4.5 mm and the outer diameter of 13 mm for pressing under the pressure of 40 MPa for 1 minute with the press machine. The molded material prepared was left standing at 140°C for 2 hours in the hot air dryer to prepare the specimen for examining the complex magnetic permeability. The outer diameter, the length in the minor axis direction, and the inner diameter of the molded specimen for examination were measured and input into the examination apparatus before examination. The complex magnetic permeability (real part magnetic permeability: µ' and imaginary part magnetic permeability: µ") was examined at the amplitude of 100 mV with a logarithmic sweep in the range of 1 MHz to 1 GHz. Note that the magnetic permeability µ' in Table 3 is the value at 13.56 MHz.

### (Determination of the magnetic properties)

The magnetic properties were examined by using the vibrating sample magnetometer (model: VSM-C7-10A (manufactured by Toei Industry Co., Ltd.)). The cell with the inner diameter of 5 mm and the height of 2 mm was filled with the sample to be examined (ferrite particle) and set in the apparatus. In the examination, sweeping was carried out up to 5K·1000/4π·A/m under applied magnetic field. Subsequently the applied magnetic field was reduced to draw the hysteresis curve on the recording paper. Based on the hysteresis curve, the magnetization under the applied magnetic field of 5K·1000/4π·A/m was determined. The residual magnetization and the coercive force were determined in the same manner.

**[Table 1]**

| | Raw material charged (mol) | | | | Firing condition | | Fine pulverization | Hydrophilic ink | | |
|---|---|---|---|---|---|---|---|---|---|---|
| | Fe₂O₃ | NiO | ZnO | CuO | Firing temperature (°C) | Firing atmosphere | Slurry particle diameter (µm) | Solid content (wt%) | Binder component (10 wt% PVA aqueous solution) | Viscosity (cps) |
| Example 1 | 49 | 15 | 30 | 6 | 1000 | Air | 0.965 | 80 | 2 | 1500 |
| Example 2 | 49 | 15 | 30 | 6 | 1000 | Air | 0.965 | 85 | 2 | 2500 |
| Example 3 | 49 | 15 | 30 | 6 | 1000 | Air | 0.965 | 70 | 2 | 1000 |
| Example 4 | 49 | 15 | 30 | 6 | 1000 | Air | 0.965 | 80 | 2 | 1500 |
| Example 5 | 49 | 15 | 30 | 6 | 1000 | Air | 0.965 | 80 | 2 | 1500 |
| Example 6 | 49 | 15 | 30 | 6 | 1000 | Air | 0.965 | 80 | 2 | 1500 |
| Comparative Example 1 | 49 | 15 | 30 | 6 | 1000 | Air | 0.965 | 80 | 2 | 1500 |
| Comparative Example 2 | 49 | 15 | 30 | 6 | 1000 | Air | 0.965 | 80 | 2 | 1500 |

**[Table 2]**

| | Coating conditions | | | | | Binder removing conditions | | Final firing conditions | |
|---|---|---|---|---|---|---|---|---|---|
| | Coating method | Coating thickness (µm) | Film traveling speed (m/min) | Film surface temperature (°C) | Liquid for peeling | Treatment temperature (°C) | Heating atmosphere | Firing temperature (°C) | Firing atmosphere |
| Example 1 | Comma coater | 12 | 5 | 63 | MEK | 650 | Air | 1220 | Air |
| Example 2 | Comma coater | 12 | 5 | 63 | MEK | 650 | Air | 1220 | Air |
| Example 3 | Comma coater | 12 | 5 | 63 | MEK | 650 | Air | 1220 | Air |
| Example 4 | Comma coater | 12 | 5 | 63 | MEK | 650 | Air | 1165 | Air |
| Example 5 | Comma coater | 38 | 5 | 59 | MEK | 650 | Air | 1220 | Air |
| Example 6 | Comma coater | 8 | 5 | 68 | MEK | 650 | Air | 1220 | Air |
| Comparative Example 1 | Comma coater | 12 | 5 | 68 | MEK | 650 | Air | 1050 | Air |
| Comparative Example 2 | Comma coater | 12 | 5 | 68 | MEK | 650 | Air | 1310 | Air |

**[Table 3]**

| | Properties of plate shaped particle prepared | | | | | | | | | |
|---|---|---|---|---|---|---|---|---|---|---|
| | Metallic luster | Length in minor axis direction (µm) | Length in major axis direction (µm) | Aspect ratio | Surface roughness BET measured specific with laser surface microscope area (m²/g) (Ra)(µm) | | Magnetic permeability µ' | Magnetic properties at 5K·1000/4πA/m (VSM) | | |
| | | | | | | | | Magnetization (Am²/kg) | Residual magnetization (Am ²/kg) | Coercive force (A/m) |
| Example 1 | Present | 9 | 352 | 39.11 | 1.89 | 0.0892 | 28 | 48.13 | 2.43 | 25.09 |
| Example 2 | Present | 11 | 463 | 42.09 | 0.98 | 0.0785 | 27 | 47.77 | 3.27 | 25.82 |
| Example 3 | Present | 8 | 278 | 34.75 | 2.02 | 0.1039 | 28 | 47.33 | 3.07 | 26.75 |
| Example 4 | Present | 10 | 410 | 41 | 2.78 | 0.1188 | 28 | 47.84 | 3.25 | 27.38 |
| Example 5 | Present | 32 | 958 | 29.94 | 1.76 | 0.0689 | 25 | 47.49 | 2.73 | 27.4 |
| Example 6 | Present | 6 | 189 | 31.5 | 1.87 | 0.0811 | 30 | 47.46 | 3.31 | 27.94 |
| Comparative Example 1 | Absent | 7 | 54 | 7.71 | 3.33 | 0.1589 | 19 | 45.4 | 2.4 | 26.86 |
| Comparative Example 2 | Absent | Irregular shape | | | | 0.0543 | 12 | 48 | 2.56 | 27.46 |

As shown in Table 3, the plate shaped ferrite particles having the small surface roughness with the metallic luster are prepared in Examples 1 to 6. In contrast, sufficient metallic luster is not achieved in Comparative Example 1 because the excessively low firing temperature made the grain growth insufficient, and increased the surface roughness. No plate shaped ferrite particle is prepared in Comparative Example 2 because the excessively high firing temperature make the ferrite particles bond to each other by melting. Furthermore, the magnetic permeabilities in Comparative Examples 1 and 2 are lower than that in Examples 1 to 6, and magnetic shielding effect in Comparative Examples 1 and 2 is poor.

### <Example 7>

### (Preparation of the resin molded material)

The mixture of 60 wt% of a binder rein (10 wt% PVA aqueous solution) and 40 wt% of the plate shaped ferrite particles prepared in Example 1 were mixed, dispersed, and coated on a PET film with the applicator (10 mil). The coated film was dried to remove water content and then peeled from the PET film to prepare the resin molded material. The resin molded material was confirmed to have the metallic luster and excellent designability.

### <Example 8>

### (Manufacturing of the housing using the resin molded material)

A plurality of resin molded materials prepared in Example 7 were stacked and put between beveled dies to manufacture the housing and then heated and pressed. The housing curved surface processed is confirmed to have the metallic luster and excellent designability.

### [Industrial Applicability]

As the plate shaped ferrite particle for a pigment according to the present invention has a metallic luster, not only electromagnetic wave shielding ability but also designability can be achieved. As a result, a resin molded material can be prepared by using the plate shaped ferrite particle for a pigment, and an electromagnetic wave shield housing for storing an electronic circuit can be manufactured by using the resin molded material. As the resin molded material formed by using the ferrite particle is not in a tile form and a resin has flexibility, the electromagnetic wave shield housing according to the present invention can be formed by curved surface processing, and also has designability. Furthermore, since the ferrite as oxide causes no surface oxidation, a stable state for a long period is assured.

## Claims

1. A plate shaped ferrite particle for a pigment **characterized in** having a metallic luster, wherein the ferrite particle has a length in a minor axis direction of 3 to 100 µm, a length in a major axis direction of 10 to 2000 µm, and a surface roughness (Ra) of 0.01 to 3 µm, as measured with a laser microscope.

2. A resin molded material containing the plate shaped ferrite particle for a pigment according to claim 1.

3. An electromagnetic wave shield housing for storing an electronic circuit made of the resin molded material according to claim 2.

4. Use of the resin molded material according to claim 2 in an electromagnetic wave shield housing for storing an electronic circuit.

## Patentansprüche

1. Ein plättchenförmiges Ferritteilchen für ein Pigment, **dadurch gekennzeichnet, dass** es einen metallischen Glanz aufweist, wobei das Ferritteilchen eine Länge in Richtung der Nebenachse von 3 bis 100 µm, eine Länge in Richtung der Hauptachse von 10 bis 2000 µm, und eine Oberflächenrauheit (Ra) von 0,01 bis 3 µm, wie mit einem Lasermikroskop gemessen, aufweist.

2. Ein Harzformmaterial, enthaltend das plättchenförmige Ferritteilchen für ein Pigment nach Anspruch 1.

3. Ein Gehäuse zum Abschirmen von elektromagnetischen Wellen zur Aufbewahrung eines elektronischen Schaltkreises, hergestellt aus dem Harzformmaterial nach Anspruch 2.

4. Verwendung des Harzformmaterials nach Anspruch 2 in einem Gehäuse zum Abschirmen von elektromagnetischen Wellen zur Aufbewahrung eines elektronischen Schaltkreises.

## Revendications

1. Particule de ferrite en forme de plaque pour un pigment, **caractérisée en ce qu'**elle a un lustre métallique, dans laquelle la particule de ferrite a une longueur dans la direction de l'axe mineur de 3 à 100 µm, une longueur dans la direction de l'axe majeur de 10 à 2000 µm, et une rugosité de surface (Ra) de 0,01 à 3 µm, telles que mesurées au moyen d'un microscope à laser.

2. Matériau moulé en résine contenant la particule de ferrite en forme de plaque pour un pigment selon la revendication 1.

3. Boîtier formant écran aux ondes électromagnétiques pour le stockage d'un circuit électronique fait du matériau moulé en résine selon la revendication 2.

4. Utilisation du matériau moulé en résine selon la revendication 2 dans un boîtier formant écran aux ondes électromagnétiques pour le stockage d'un circuit électronique.
